# FASCICULE DE BREVET EUROPEEN

(11) **EP 2 336 457 B1**
(45) Date de publication et mention de la délivrance du brevet: **22.08.2012**
(21) Numéro de dépôt: 10194639.0
(22) Date de dépôt: 11.12.2010
(51) Int. Cl.: E04H 5/02, H05K 7/20, F24F 7/10, E04H 1/06

(54) **Bâtiment à salles informatiques superposées et procédé de climatisation de ce bâtiment**
Gebäude mit übereinanderliegenden IT-Räumen, und Klimatisierungsverfahren dieses Gebäudes
Superimposed computer room building and process for cooling this building

(30) Priorité: 11.12.2009 FR 0906019
(43) Date de publication de la demande: 22.06.2011
(73) Titulaire: Enia Architectes, 93100 Montreuil (FR); Celeste Management, 77200 Torcy (FR)
(72) Inventeur: Chazelle, Mathieu, 93100 Montreuil (FR); Pallubick, Simon, 93100 Montreuil (FR); Piechaczyck, Brice, 93100 Montreuil (FR); Pommier, Laurent, 75012 Paris (FR); Cazere, Bernard, 93100 Montreuil (FR); Aube, Nicolas, 75004 Paris (FR)
(74) Mandataire: Le Cacheux, Samuel L.R.

(56) Documents cités:
- WO-A1-2007/139560
- WO-A2-02/052107
- US-A1- 2009 241 578

## Description

La présente invention concerne le domaine technique des centres de calcul, également appelés en anglais data center, qui comprennent, d'une part, au moins une salle informatique à l'intérieur de laquelle sont disposés des serveurs ou d'autres matériels informatiques ou électroniques, et des moyens de raccordement aux réseaux de communications associés et, d'autre part, des moyens de fourniture d'énergie aux serveurs ainsi que des moyens de climatisation de la salle informatique. L'invention concerne plus particulièrement le domaine des bâtiments qui hébergent de tels centres de calcul.

Un élément essentiel dans la conception de ces bâtiments réside dans la mise en oeuvre des systèmes assurant le refroidissement des serveurs dans la mesure où les constructeurs de matériel informatique imposent, pour le maintien d'une garantie contractuelle des matériels, des plages de température relativement basses pour les salles hébergeant les serveurs. De plus, les systèmes de climatisation des salles informatiques constituent le second poste de consommation énergétique après les systèmes informatiques eux-mêmes dans l'exploitation des centres de calcul. Ainsi pour réduire l'impact énergétique d'un centre de calcul une voie possible d'économie est la recherche d'une optimisation des systèmes de climatisation des salles informatiques tant en ce qui concerne le traitement et la climatisation de l'air des salles qu'en ce qui concerne le circuit aéraulique de l'air des salles.

Afin de simplifier le circuit aéraulique une demande internationale WO 02/052 107 a proposé d'aménager la salle informatique dans un hangar et de placer, le matériel informatique ainsi que les systèmes d'alimentation électrique sécurisée associés et les moyens de raccordement aux réseaux de communications, sur différentes mezzanines superposées dont le plancher est grillagé pour permettre une libre circulation de l'air autour des matériels à refroidir. Cette demande internationale propose en plus d'assurer une circulation de l'air à l'intérieur de la salle informatique par convection naturelle en aménageant, d'une part, en partie basse des murs du hangar des entrées d'air et, d'autre part, au niveau du toit du hangar des évacuations d'air. Une telle conception de la salle informatique présente toutefois l'inconvénient d'imposer l'utilisation d'un volume important pour un nombre restreint de serveurs et ne permet pas une bonne maîtrise de la température de l'air au niveau des serveurs.

Afin de répondre à ce problème de la maîtrise de la température de l'air au niveau des serveurs, une demande japonaise JP2009-79890 a proposé une salle informatique à l'intérieur de laquelle des armoires de réception des serveurs sont disposées en deux rangées dos à dos pour définir entre elles un couloir d'apport d'air frais fermé par un plafond et des portes souples qui l'isole du reste de la salle informatique. La salle informatique comprend en outre un faux plancher ouvert au niveau du couloir d'apport d'air frais. La climatisation de la salle informatique est alors assurée par un système fonctionnant en circuit fermé en aspirant l'air de la salle à l'extérieur du couloir d'apport d'air frais et des armoires informatiques pour le refouler dans le faux plancher. Ainsi, l'air frais est contraint de passer au travers des armoires informatiques avant d'être refroidi et recyclé. Dans le même esprit que la demande JP2009-79890 une demande américaine US 2009/0241578 a proposé une salle informatique à l'intérieur de laquelle des armoires de réception des serveurs sont disposées en deux rangées dos à dos pour définir entre elles des plenums de collecte de l'air chaud tandis l'espace situé en façade des armoires forme une zone d'air frais. Les plenums et la zone d'air frais communiquent via un faux plancher avec une zone de traitement et de refroidissement de l'air. De tels systèmes permettent une bonne maîtrise de la température de l'air au niveau des serveurs dans la mesure où il évite un mélange de l'air refroidi avec l'air chaud sortant des serveurs au contraire du système proposé par la demande internationale WO 02/052107. Cependant, les systèmes japonais ou américain présentent l'inconvénient d'imposer la mise en oeuvre d'un système de climatisation et d'un faux plancher pour chaque salle informatique ainsi que d'induire de fortes pertes de charges aérauliques compte tenu du circuit de l'air recyclé.

II est donc apparu le besoin d'un nouveau type de bâtiment comprenant des salles informatiques qui permette une optimisation du système de climatisation notamment en ce qui concerne le circuit aéraulique ainsi qu'une réduction de la consommation énergétique pour la climatisation des salles informatiques.

Afin d'atteindre ces objectifs, l'invention concerne un bâtiment comprenant au moins deux salles informatiques superposées qui sont délimitées chacune par une paroi périphérique et séparées l'une de l'autre par un plancher intermédiaire et qui renferment chacune des armoires informatiques de réception de matériel informatique ou électronique. Selon l'invention ce bâtiment est caractérisé en ce :
- chaque salle informatique comprend au moins une paroi intérieure qui est formée en partie ou moins par les armoires informatiques et qui sépare le volume intérieur de chaque salle informatique en une zone chaude et une zone froide, l'air ne pouvant circuler entre la zone chaude et la zone froide qu'en passant au travers des armoires informatiques,
- les zones chaudes et respectivement froides sont superposées d'un étage à l'autre,
- chaque plancher intermédiaire est ajouré de manière à permettre une libre circulation de l'air, d'une part, entre les zones chaudes superposées et, d'autre part, entre les zones froides superposées, l'ensemble des zones froides superposées formant une colonne d'alimentation en air frais et l'ensemble des zones chaudes superposées formant une colonne d'évacuation de l'air chaud,
- les planchers, les parois périphériques et les parois intérieures sont adaptés pour faire obstacle à une circulation directe d'air entre la colonne d'alimentation et la colonne d'évacuation,
- et le bâtiment comprend des moyens d'apport d'air frais dans la colonne d'alimentation et des moyens d'évacuation de l'air chaud de la colonne d'évacuation.

La conception du bâtiment selon l'invention permettant de définir une colonne d'alimentation et une colonne d'évacuation communes à l'ensemble des salles informatiques permet d'obtenir un circuit aéraulique induisant de très faibles pertes de charge par comparaison aux systèmes connus. De plus, la circulation de l'air entre la colonne d'alimentation et la colonne d'évacuation s'effectue principalement voire exclusivement au travers des armoires informatiques de sorte qu'il n'y a pas de mélange non contrôlé entre l'air frais et l'air chaud et qu'il est possible de maîtriser au mieux la température de l'air frais fourni aux systèmes informatiques ou électroniques.

Selon l'invention, le bâtiment comprenant les salles informatiques n'est pas nécessairement un bâtiment dédié uniquement à l'hébergement d'un centre de calcul mais peut aussi comprendre des salles à vocation diverse telles que par exemple des salles de bureaux, de réunion, de restauration ou autre. De plus, le bâtiment selon l'invention n'est pas nécessairement un bâtiment neuf mais peut également être un bâtiment préexistant qui a été modifié de manière à y intégrer des salles informatiques superposées conformes à l'invention. Par ailleurs, les salles informatiques d'un bâtiment conforme à l'invention ne présentent pas toutes nécessairement la même surface, ni la même configuration géométrique, l'essentiel étant qu'elles soient séparées par des planchers ajourés permettant une libre circulation de l'air entre, d'une part, les zones froides et, d'autre part, les zones chaudes, étant entendu que les zones froides et les zones chaudes ne présentent pas nécessairement toutes une forme identique.

Au sens de l'invention, il convient d'entendre par plancher ajouré un plancher susceptible de laisser passer l'air tout en permettant à des opérateurs d'y stationner en toute sécurité. Un plancher ajouré selon l'invention peut par exemple comprendre des zones pleines ou fermées associées à des zones ouvertes. Un plancher ajouré selon l'invention peut également être formé par un treillis ou un caillebotis, par exemple mais non exclusivement métallique, permettant une libre circulation de l'air au travers de quasiment toute sa surface. Ainsi, il est possible de d'obtenir un plancher ajouré présentant un coefficient d'ouverture supérieure à 40 % voire à 80 % engendrant de très faibles pertes de charges.

Bien entendu, selon l'invention les salles informatiques ainsi que les zones froides et chaudes qui y sont aménagées peuvent également présenter des formes sensiblement similaires d'une salle à l'autre. Ainsi, selon une forme de réalisation d'un bâtiment conforme à l'invention :
- les parois périphériques des salles informatiques sont superposées et forment une partie de la structure porteuse du bâtiment,
- et les parois intérieures sont superposées d'une salle informatique à l'autre.

Un tel mode de réalisation du bâtiment permet d'optimiser la circulation de l'air au sein des colonnes d'alimentation et d'évacuation en réduisant les pertes de charges et les zones mortes.

Selon une caractéristique de l'invention, les armoires informatiques sont réalisées de manière à, d'une part, privilégier le passage de l'air de la zone froide à la zone chaude correspondante par les régions des armoires comprenant du matériel électronique et, d'autre part, limiter, autant que faire se peut, le passage de l'air par les régions vides des armoires. À cet effet, chaque armoire informatique peut comprendre des cloisons et/ou des partitions en partie au moins amovibles adaptées pour faire obstacle à la libre circulation de l'air dans les parties de l'armoire ne comprenant pas de matériel informatique ou électronique.

Selon l'invention, la circulation de l'air à l'intérieur des armoires informatiques peut simplement résulter d'une différence de pression entre la colonne d'alimentation et la colonne d'évacuation. Toutefois, la circulation de l'air intérieur des armoires informatiques peut également être forcée. À cet effet, le bâtiment selon l'invention peut comprendre du matériel informatique ou électronique disposé dans au moins une armoire informatique et adapté pour aspirer l'air frais au niveau d'une face orientée vers la zone froide correspondante et pour refouler l'air chaud au niveau d'une face orientée vers la zone chaude correspondante.

Selon l'invention, les zones froides et chaudes de chaque salle informatique peuvent présenter des surfaces égales ou différentes. Dans une forme de réalisation de l'invention, les armoires informatiques étant généralement conçues pour que les matériels informatiques soient introduits ou retirés par la façade en zone froide, chaque salle informatique pourra être réalisée de manière que la surface, mesurée au niveau du plancher, de chaque zone froide est supérieure ou égale à la surface, mesurée au niveau du plancher, de la zone chaude correspondante.

Selon une forme de réalisation de l'invention visant à optimiser les performances énergétiques du bâtiment en ce qui concerne la climatisation des salles informatiques, le bâtiment comprend au moins un escalier et/ou un ascenseur d'accès aux salles informatiques qui est disposé à l'extérieur des salles informatiques. Ainsi, il est possible de limiter le volume des salles informatiques au seul volume nécessaire au stockage des armoires informatiques et aux d'interventions, dans de bonnes conditions de travail, sur le matériel électronique ou informatique qu'elles renferment.

Selon l'invention, l'apport en air frais et l'évacuation de l'air chaud peuvent être réalisés de toute manière appropriée.

Ainsi, selon une forme de réalisation de l'invention, les moyens d'apport d'air frais et d'évacuation de l'air chaud comprennent des conduites d'air frais et des conduites d'air chaud raccordées à au moins une installation de climatisation et/ou de traitement de l'air.

Selon une variante de cette forme de réalisation, le bâtiment comprend alors sous la salle informatique la plus basse au moins :
- une chambre d'apport d'air frais qui est séparée de la zone froide de la salle la plus basse par un plancher ajouré autorisant une libre circulation de l'air et qui est raccordée à l'installation de climatisation et/ou de traitement de l'air,
- une chambre d'évacuation de l'air chaud qui est séparée de la zone chaude de la salle la plus basse par un plancher ajouré autorisant une libre circulation de l'air et qui est raccordée à l'installation de climatisation et/ou de traitement de l'air.

Dans le cadre de cette première variante de réalisation, l'installation de climatisation et/ou de traitement de l'air pourra être située au sol et/ou en sous-sol. Ainsi, il n'est pas nécessaire de dimensionner la structure du bâtiment de manière qu'elle puisse supporter en hauteur la charge importante de l'installation de climatisation et de traitement air.

Selon une deuxième variante de cette forme de réalisation, le bâtiment comprend, au niveau ou au dessus de la salle informatique la plus haute, au moins :
- une chambre d'apport d'air frais qui est séparée de la zone froide de la salle la plus haute par une cloison ajourée autorisant une libre circulation de l'air et qui est raccordée à l'installation de climatisation et/ou de traitement de l'air,
- une chambre d'évacuation de l'air chaud qui est séparée de la zone chaude de la salle la plus haute par une cloison ajourée autorisant une libre circulation de l'air et qui est raccordée à l'installation de climatisation et/ou de traitement de l'air.

Dans le cadre de cette deuxième variante, l'installation de climatisation et/ou de traitement de l'air peut être située au dessus ou au niveau de la salle informatique la plus haute. Ainsi, il est possible de mettre à profit la convection naturelle au sein des colonnes d'alimentation et d'évacuation pour contribuer à la circulation de l'air dans ces dernières.

Afin de favoriser la circulation de l'air au travers des armoires informatiques, l'installation de climatisation et/ou de traitement pourra être adaptée pour placer la colonne d'apport d'air frais en surpression et la colonne d'évacuation de l'air chaud en dépression.

Selon l'invention l'évacuation de l'air chaud peut également être assurés par convection naturelle, au sein de la colonne d'évacuation. Ainsi, selon une autre variante de réalisation les moyens d'évacuation de l'air chaud comprennent au moins une bouche de sortie ouverte vers l'extérieur au niveau de la zone chaude de la salle informatique la plus haute.

De la même manière, l'air provenant de l'extérieur peut ne pas provenir d'une installation de climatisation ajustant sa température. A cet effet, selon une autre variante de réalisation du bâtiment les moyens d'apport d'air frais comprennent au moins une bouche d'entrée d'air extérieur au niveau de la zone froide de la salle informatique la plus basse. Dans ce cas la circulation de l'air pourra être forcée par une soufflerie aspirant l'air de la colonne d'évacuation. Il doit être noté que chaque bouche d'entrée et/ou de sortie pourra être obturée par au moins un volet mobile permettant d'en contrôler le degré d'ouverture.

Selon l'invention l'alimentation et l'évacuation de l'air du bâtiment peuvent également être assurées par convection naturelle sans recours à une installation de climatisation. A cet effet, selon une autre variante de réalisation, le bâtiment comprend à la fois des bouches d'entrée et de sortie qui pourront être totalement ou partiellement obturées par des volets mobiles.

De plus, il pourra être prévu au niveau des bouches d'entrée d'air, en amont ou en aval, des moyens de filtration de l'air avant son entrée dans la colonne d'alimentation.

Dans une forme de réalisation visant à favoriser les phénomènes de convection, au sein du bâtiment selon l'invention, chaque salle informatique possède une hauteur comprise entre 2 m et 3 m et le bâtiment comprend au moins quatre étages de salles informatiques.

L'invention concerne également un procédé de régulation de la température des salles informatiques d'un bâtiment conforme à l'invention. Un tel le procédé de régulation est **caractérisé en ce qu**'il consiste notamment à :
- dans un mode de fonctionnement, dit hiver, lorsque l'air extérieur est à une température inférieure ou égale à une température limite ou maximale préconisée, mettre en oeuvre les étapes suivantes :
   - évacuer vers l'extérieur une partie de l'air chaud en provenance de la colonne d'air chaud
   - prélever de l'air extérieur et le mélanger avec la partie restante de l'air chaud en provenance de la colonne d'évacuation pour obtenir un air mélangé frais à une température comprise dans une plage de température préconisée,
   - alimenter la colonne d'alimentation avec l'air mélangé frais obtenu,
- dans un mode de fonctionnement, dit mi-saison, lorsque l'air extérieur est à une température supérieure à la température limite ou maximale préconisée et inférieure la température de l'air en sortie des matériels informatiques ou électroniques, mettre en oeuvre les étapes suivantes :
   - évacuer vers l'extérieur une partie au moins de l'air chaud en provenance de la colonne d'air chaud,
   - prélever de l'air extérieur et le mélanger éventuellement avec la partie restante de l'air chaud en provenance de la colonne d'évacuation pour obtenir un air mélangé,
   - refroidir l'air extérieur ou l'air mélangé pour obtenir un air frais à une température comprise dans la plage de température préconisée,
   - alimenter la colonne d'alimentation avec l'air mélangé frais obtenu,
- dans un mode de fonctionnement, dit été, lorsque l'air extérieur est à une température supérieure à la température de l'air en sortie des matériels informatiques ou électroniques, mettre en oeuvre les étapes suivantes :
   - recycler totalement l'air chaud en provenance de la colonne d'air chaud,
   - refroidir l'air chaud recyclé pour obtenir un air recyclé à une température comprise dans la plage de température préconisée,
   - alimenter la colonne d'alimentation avec l'air recyclé frais obtenu.

Selon une variante de mise en oeuvre du mode de fonctionnement mi-saison, l'air en provenance de la colonne d'évacuation est intégralement évacué vers l'extérieur et l'intégralité de l'air insufflé dans la colonne d'alimentation est de l'air extérieur climatisé et/ou traité. Dans cette variante de fonctionnement, l'air chaud sera de préférence mais non exclusivement évacué par la ou les bouches de sorties hautes de manière à profiter de la convection naturelle.

Selon une forme de mise en oeuvre, ce procédé consiste notamment dans un mode de fonctionnement dit économique à assurer l'alimentation en air de la colonne d'apport et l'évacuation de l'air chaud de la colonne d'évacuation en partie au moins par convection naturelle en contrôlant l'ouverture des volets des bouches d'entrée et de sortie.

Selon une variante de mise en oeuvre, ce procédé comprend une étape de contrôle et d'ajustement de l'hygrométrie de l'air alimentant la colonne d'apport. Le procédé pourra également comprendre une étape de filtration de l'air alimentant la colonne d'alimentation.

L'invention concerne en outre un procédé de régulation de la température des salles informatiques d'un bâtiment conforme à l'invention consistant à assurer l'alimentation en air de la colonne d'alimentation et l'évacuation de l'air chaud de la colonne d'évacuation en partie au moins par convection naturelle. Ce procédé pourra également comprendre une étape de filtration de l'air avant son admission dans la colonne d'alimentation.

Bien entendu les différentes variantes et formes de réalisation de l'invention peuvent être associées les unes avec les autres selon diverses combinaisons dans la mesure où elles ne sont pas incompatibles ou exclusives les unes des autres.

Par ailleurs, diverses autres caractéristiques de l'invention ressortent de la description annexée effectuée en référence aux dessins qui illustrent des formes non limitatives de réalisation d'un bâtiment comprenant des salles informatiques superposées conformément à l'invention.
- La figure 1 est perspective partiellement arrachée d'un bâtiment, conforme à l'invention, comprenant des salles informatiques superposées dans le sens de la hauteur.
- La figure 2 est une vue en plan d'un étage, du bâtiment illustré à la figure 1, avec une salle informatique ; les étages du bâtiment avec salle informatique ayant sensiblement tous la même configuration.
- La figure 3 est une vue en coupe d'une forme de réalisation d'une armoire informatique constitutive d'une paroi intérieure d'une salle informatique du bâtiment illustré à la figure 1.
- La figure 4 est une vue en plan d'un étage d'un bâtiment selon une autre forme de réalisation de l'invention.

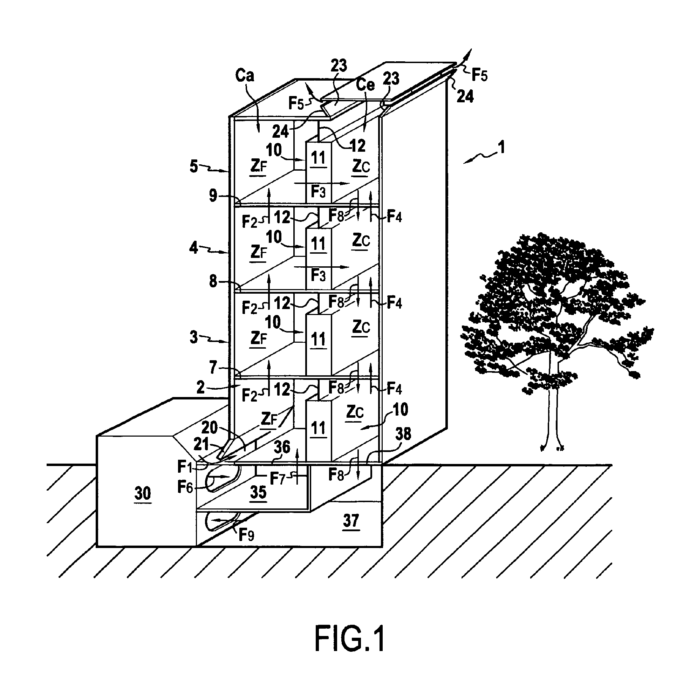

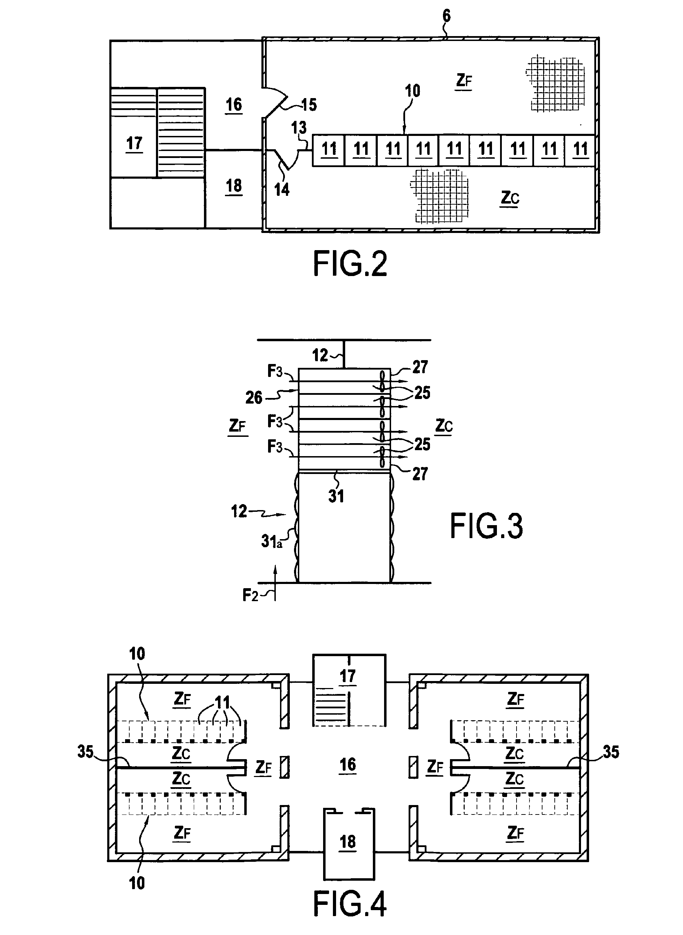

Un bâtiment selon l'invention, tel qu'illustré figure **1****,** **2** et désigné dans son ensemble par la référence **1,** comprend au moins deux et, selon l'exemple de la figure 1, quatre salles informatiques **2, 3, 4, 5** superposées, étant entendu que le bâtiment **1** pourrait comprendre plus de quatre salles informatiques superposées. Chaque salle informatique est délimitée par une paroi périphérique **6** qui, selon l'exemple illustré, est commune à toutes les salles informatiques et forme une paroi extérieure porteuse du bâtiment **1.** Ainsi, dans le cas présent toutes les salles informatiques **2, 3, 4, 5** possèdent la même forme et la même surface intérieure. Les salles informatiques **2, 3, 4** et **5** sont en outre séparées les unes des autres par des planchers intermédiaires **7, 8, 9**.

Chaque salle informatique comprend, par ailleurs, une paroi intérieure **10** qui est en partie formée par la juxtaposition d'armoires informatiques **11** accolées les unes aux autres. La paroi intérieure **10** de chaque salle informatique est également formée par un panneau supérieur **12** qui est interposé entre les armoires informatiques **11** et le plafond de la salle informatique correspondante. La paroi intérieure **10** comprend également un panneau latéral **13** interposé entre une armoire informatique extrémité et la paroi périphérique **6.** La paroi intérieure **10** délimite ainsi dans la salle informatique correspondante une zone froide **Zf** est une zone chaude **Zc.** Selon l'exemple illustré le panneau latéral **13** comprend une porte intérieure **14** permettant d'accéder à la zone chaude **Zc** à partir de la zone froide **Zf** tandis que l'accès à l'intérieur de la salle informatique s'effectue par une porte extérieure **15** qui est aménagée dans la paroi périphérique **6** pour s'ouvrir dans la zone froide **Zf.** La porte extérieure **15** est desservie, à partir d'un palier extérieur **16**, par un escalier **17** et un ascenseur **18** tous deux situés à l'extérieur des salles informatiques **2** à **5.**

Chaque paroi intérieure **10** est alors conçue pour que la circulation d'air, entre les zones froide **Zf** et chaudes **Zc** correspondantes, se fasse principalement voire exclusivement au travers des armoires informatiques **11.** L'espace entre les armoires informatiques 11 sera alors inexistant ou obturé.

Conformément à une caractéristique essentielle de l'invention, chaque plancher intermédiaire **7, 8, 9** est ajouré de manière à permettre une libre circulation de l'air entre les zones froides **Zf,** d'une part, et les zones chaudes **Zc** d'autre part. Selon l'exemple illustré les parties ajourées de chaque plancher intermédiaire sont réalisées au moyen d'un caillebotis de tôle partiellement illustré à la figure 2. Selon l'exemple représenté, l'intégralité de la surface du plancher intermédiaire est constituée par le caillebotis ce qui permet d'obtenir un coefficient d'ouverture supérieur à 80%. La partie du plancher situé au niveau des armoires informatiques **11** sera alors obturée de manière à empêcher une circulation directe de l'air entre les zones froides **Zf** et chaudes **Zc** correspondantes.

La mise en oeuvre des planchers intermédiaires ajourés permet à l'ensemble des zones froides **Zf** superposées de constituer une colonne d'alimentation **Cₐ** tandis que les zones chaudes **Zc** superposées forment une colonne d'évacuation **Cₑ** que comme cela ressortira de la suite.

La climatisation des salles informatiques **2** à **5** superposées et donc le refroidissement des matériels électroniques ou informatiques placés dans les armoires **11** peut alors être réalisé d'au moins deux manières différentes.

Le moyen le plus économique de réaliser cette climatisation en consommant un minimum d'énergie est de mettre à profit la convection naturelle. À cet effet, il est aménagé dans la paroi périphérique de la zone froide **Zf** de la salle informatique la plus basse **2,** au moins une bouche d'entrée d'air **20** qui, selon l'exemple illustré, est ouverte vers l'extérieur et commandée par un volet mobile **21** permettant d'en ajuster l'ouverture. Il est en outre aménagé au niveau du plafond de la zone chaude **Zc** de la salle informatique la plus haute **5,** au moins une et, selon l'exemple illustré, deux bouches de sortie **23** qui sont ouvertes vers l'extérieur et commandées par un volet mobile **24** permettant d'en ajuster l'ouverture. La bouche d'entrée **20** est alors constitutive de moyens d'apport d'air frais tandis que les bouches de sortie **23** sont constitutives de moyens d'évacuation de l'air chaud.

La circulation de l'air, dans cette configuration du bâtiment selon l'invention, s'effectue de la manière suivante.

L'air extérieur entre dans la salle informatique la plus basse **2** par la bouche d'entrée d'air **20,** comme indiqué par la flèche **F1** et monte dans la colonne d'alimentation en traversant les planchers intermédiaires **7** à **9** comme le montrent les flèches **F2.** Ensuite l'air frais traverse les armoires informatiques comme représenté par les flèches **F3.** A l'intérieur des armoires informatiques l'air se réchauffe au contact du matériel électronique ou informatique **25** qui s'y trouve.

A cet égard, il doit être remarqué que chaque matériel informatique **25** est disposé dans les armoires de manière que le système de ventilation, qui l'équipe éventuellement, induise une aspiration de l'air à partir d'une face **26** orientée vers la zone froide **Zf** et un refoulement de l'air par une face **27** orientée vers la zone chaude **Zc.** De plus, afin d'éviter que l'air frais ne passe pas par le matériel informatique **25,** chaque armoire **11** comprend de préférence des cloisons **31a** et des partitions **31** amovibles faisant obstacle à la circulation de l'air dans les parties vides de chaque armoire informatique **11.**

Après avoir traversé les armoires informatiques **11,** l'air chaud se trouve dans les zones chaudes **Zc** et monte dans la colonne d'évacuation **Ce** sous l'effet de la convection naturelle en traversant les planchers intermédiaires **7** à **9** comme le montrent les flèches **F4,** pour être ensuite évacué vers l'extérieur par les bouches **23** comme le montrent les flèches **F5.**

Il est à noter que dans une forme de réalisation préférée mais non strictement nécessaire visant à favoriser l'effet cheminée au sein de la colonne d'évacuation **Cₑ**, le bâtiment comprendra au moins quatre étages de salles informatiques superposées **2** à **5** possédant chacune une hauteur comprise entre 2 m et 3 m.

Bien entendu, la convection naturelle n'est pas le seul mode de climatisation possible du bâtiment **1** selon l'invention.

Ainsi, il peut également être mis en oeuvre une installation **30** de climatisation et de traitement de l'air pour assurer l'alimentation en air frais, sa filtration, et l'évacuation de l'air chaud. Les moyens d'apport d'air frais comprennent alors, selon l'exemple illustré, une chambre **35** d'apport d'air frais située sous la zone froide **Zf** de la salle informatique la plus basse **2.** Cette chambre d'apport d'air frais **35** est alors séparée de la zone froide **Zf** par un plancher ajouré **36** réalisé de la même façon que les planchers intermédiaires **7** à **9.** La chambre d'apport **35** est alors raccordée à l'installation **30** soit directement, soit par l'intermédiaire de canalisation ou de conduites de ventilation.

De façon analogue, les moyens d'évacuation de l'air chaud comprennent alors une chambre d'évacuation et/ou de recyclage de l'air chaud **37** située sous la zone chaude **Zc** de l'étage informatique le plus bas **2** dont elle est séparée par un plancher ajouré **38** réalisé de la même manière que les planchers intermédiaires **7** à **9.** La chambre d'évacuation et/ou recyclage **37** est alors raccordée à l'installation **30** soit directement, soit par l'intermédiaire de canalisation ou de conduites de ventilation. Bien entendu la chambre d'apport **35** et la chambre d'évacuation et/ou de recyclage **37** ainsi que leurs éventuelles canalisations ou conduits associés sont isolés ou séparés les uns des autres.

Lorsque l'installation de climatisation **30** est utilisée, les volets **21** et **24** peuvent être fermés. L'air frais est alors fourni par l'installation **30** en étant insufflé dans la chambre d'apport **35** comme le montre la flèche **F6** pour ensuite traverser le plancher **36** comme indiqué par la flèche **F7.** L'air frais poursuit ensuite son trajet comme décrit précédemment et indiqué par les flèches **F2** et **F3.** Une fois dans la colonne d'évacuation **Ce** l'air peut être aspiré vers le bas et suivre le trajet indiqué par des flèches **F8** pour arriver dans la chambre d'évacuation et/ou recyclage **37** à partir de laquelle il est aspiré par l'installation **30** comme illustré par la flèche **F9.** L'air dans la colonne d'évacuation peut aussi être évacué vers le haut et suivre le trajet indiqué les flèches **F4** et **F5** pour être évacuer totalement ou partiellement par les bouches **23.**

Dans une forme de réalisation préférée mais non strictement nécessaire visant à réduire autant que faire se peut la consommation énergétique liée à la climatisation des salles informatiques, l'installation **30** sera conçue pour passer automatiquement, selon les conditions extérieures, un mode de fonctionnement choisi parmi moins trois modes de fonctionnement dits hiver, mi-saison et été.

Ainsi, lorsque l'air extérieur est à une température inférieure ou égale à une température maximale préconisée ou limite, l'installation passe en mode de fonctionnement hiver. Cette température maximale ou limite dépend généralement des préconisation des constructeurs du matériel informatique ou électronique hébergé ou encore du choix de l'exploitant du bâtiment selon l'invention. La température limite peut, par exemple mais non exclusivement, choisie à 23°C. En mode de fonctionnement hiver, l'installation **30** évacue alors vers l'extérieur une partie de l'air chaud en provenance de la colonne d'air chaud. Concomitamment l'installation **30** prélève de l'air extérieur et le mélange avec la partie restante de l'air chaud en provenance de la colonne d'évacuation pour obtenir un air mélangé frais à une température comprise dans une plage de température préconisée par les constructeurs du matériel électronique ou informatique placé dans les armoires **11.** L'installation **30** insuffle alors l'air mélangé frais obtenu dans la colonne d'alimentation. La plage de température préconisée peut également être déterminée par l'exploitant du bâtiment et pourra par exemple mais non exclusivement choisie comme étant la plage de 17°C à 23°C.

Lorsque l'air extérieur est à une température supérieure à la température limite ou maximale préconisée et inférieure la température de l'air en sortie des matériels informatiques ou électroniques, généralement mais non exclusivement supérieure à 30°C, l'installation **30** passe dans un variante possible du mode de fonctionnement mi-saison, mettant en oeuvre les étapes suivantes :
- évacuation vers l'extérieur de l'air chaud en provenance de la colonne d'air chaud,
- prélèvement d'air extérieur,
- refroidissement de l'air extérieur pour obtenir un air frais à une température comprise dans la plage de température préconisée,
- alimentation la colonne d'alimentation avec l'air frais obtenu,

Dans cette variante du mode mi-saison, l'air chaud sera de préférence mais non exclusivement évacué par les bouches **23** afin de mettre à profit la convection naturelle et ainsi réduire la consommation énergétique liée au soufflage et/ou à l'aspiration de l'air.

Lorsque l'air extérieur est à une température supérieure à la température de l'air en sortie des matériels informatiques ou électroniques, l'installation **30** passe en mode de fonctionnement été. Dans ce mode été, l'air circule en circuit fermé dans les salles informatiques et l'installation de climatisation **30.** Ainsi, cette dernière recycle totalement l'air chaud en provenance de la colonne d'air chaud, le refroidit pour obtenir un air recyclé à une température comprise dans la plage de température préconisée et, enfin, alimente la colonne d'alimentation **Cₐ** avec l'air recyclé frais obtenu.

Il est à noter que lorsqu'il est mis en oeuvre une installation de climatisation **30** cette dernière peut en outre être équipée de moyens permettant de contrôler l'hygrométrie de l'air insufflé dans la colonne d'alimentation **Cₐ**.

De plus, dans le cas de la mise en oeuvre d'une installation de climatisation **30,** le mode de convection naturelle peut être utilisé en cas de dysfonctionnement complet de l'installation de climatisation **30.** Bien entendu, un bâtiment selon l'invention peut également être dépourvu des bouches d'entrée **20** et de sortie **23** permettant sa ventilation par convection naturelle.

Par ailleurs, il doit être remarqué que le bâtiment et les salles informatiques ne présentent pas nécessairement une forme telle que décrite en relation avec les figures **1** et **2****.** Ainsi la figure **4** montre un étage d'un bâtiment conforme à l'invention qui comprend à chaque étage deux salles informatiques séparées par un palier **16.** De plus, selon cet exemple la paroi intérieure **10** de chaque salle informatique est formée par deux rangs d'armoires informatiques **11** placées dos à dos et séparées par une paroi intermédiaire **35** pouvant servir de support au câblage de fourniture d'énergie.

Bien entendu, diverses modifications peuvent être apportées au bâtiment et au procédé selon l'invention dans le cadre des revendications annexées.

## Revendications

1. Bâtiment comprenant au moins deux salles informatiques (**2,3,4,5**) superposées dans le sens de la hauteur qui sont délimitées chacune par une paroi périphérique (**6**) et séparées l'une de l'autre par un plancher intermédiaire (**7**) et qui renferment chacune des armoires informatiques (**11**) de réception de matériel informatique ou électronique (**25**), bâtiment dans lequel:
- chaque salle informatique (**2,3,4,5**) comprend au moins une paroi intérieure (**10**) qui est formée en partie ou moins par les armoires informatiques (**11**) et qui sépare le volume intérieur de chaque salle informatique en une zone chaude (**Zc**) et une zone froide (**Zf**), l'air ne pouvant circuler entre la zone chaude (**Zc**) et la zone froide (**Zf**) qu'en passant au travers des armoires informatiques (**11**),
- les zones chaudes (**Zc**) et respectivement froides (**Zf**) sont superposées d'un étage à l'autre,
- chaque plancher intermédiaire (**7,8,9**) est ajouré de manière à permettre une libre circulation de l'air, d'une part, entre les zones chaudes (**Zc**) superposées et, d'autre part, entre les zones froides (**Zf**) superposées, l'ensemble des zones froides (**Zf**) superposées formant une colonne d'alimentation en air frais (**Cₐ**) et l'ensemble des zones chaudes superposées formant une colonne d'évacuation de l'air chaud (**Ce**),
- les planchers (**7,8,9**), les parois périphériques (**6**) et les parois intérieures (**10**) sont adaptés pour faire obstacle à une circulation directe d'air entre la colonne d'alimentation **(Cₐ)** et la colonne d'évacuation (**Ce**),
- et le bâtiment comprend en outre des moyens d'apport (**20**) d'air frais dans la colonne d'alimentation **(Cₐ)** et des moyens d'évacuation (**23**) de l'air chaud de la colonne d'évacuation **(Cₑ).**

2. Bâtiment selon la revendication 1, **caractérisé en ce que** :
- les parois périphériques (**6**) des salles informatiques (**2,3,4,5**) sont superposées et forment une partie de la structure porteuse du bâtiment,
- et les parois intérieures (**10**) sont superposées d'une salle informatique à l'autre.

3. Bâtiment selon l'une des revendications précédentes, **caractérisé en ce que** chaque salle informatique (**2,3,4,5**) possède une hauteur comprise entre 2 m et 3 m et **en ce que** le bâtiment comprend au moins quatre étages de salles informatiques.

4. Bâtiment selon l'une des revendications précédentes, **caractérisé en ce que** chaque armoire informatique **(11)** comprend des cloisons **(31a)** et/ou des partitions **(31)** en partie au moins amovibles adaptées pour faire obstacle à la libre circulation de l'air dans les parties de l'armoire (**11**) ne comprenant pas de matériel informatique ou électronique.

5. Bâtiment selon l'une des revendications précédente, **caractérisé en ce qu**'il comprend du matériel informatique ou électronique (**25**) disposé dans au moins une armoire informatique et adapté pour aspirer l'air frais au niveau d'une face orientée (**26**) vers la zone froide (**Zf**) correspondante et pour refouler l'air chaud au niveau d'une face (**27**) orientée vers la zone chaude (**Zc**) correspondante.

6. Bâtiment selon l'une des revendications précédentes, **caractérisé en que** la surface, mesurée au niveau du plancher, de chaque zone froide (**Zf**) est supérieure ou égale à la surface, mesurée au niveau du plancher, la zone chaude (**Zc**) correspondante.

7. Bâtiment selon l'une des revendications précédentes, **caractérisé en ce qu**'il comprend au moins un escalier (**17**) et/ou un ascenseur (**18**) d'accès aux salles informatiques (**2,3, 4,5**) qui est disposé à l'extérieur des salles informatiques.

8. Bâtiment selon l'une des revendication 1 à 7, **caractérisé en ce que** les moyens d'apport d'air frais et d'évacuation de l'air chaud comprennent des conduites d'air frais et des conduites d'air chaud raccordées à au moins une installation (**30**) de climatisation et/ou de traitement de l'air.

9. Bâtiment selon la revendication 8, **caractérisé en ce qu**'il comprend sous la salle informatique la plus basse (**2**) au moins :
- une chambre (**35**) d'apport d'air frais qui est séparée de la zone froide (**Zf**) de la salle la plus basse (**2**) par un plancher ajouré (**36**) autorisant une libre circulation de l'air et qui est raccordée à l'installation (**30**) de climatisation et/ou de traitement de l'air,
- une chambre (**37**) d'évacuation de l'air chaud qui est séparée de la zone chaude (**Zc**) de la salle la plus basse (**2**) par un plancher ajouré (**38**) autorisant une libre circulation de l'air et qui est raccordée à l'installation (**30**) de climatisation et/ou de traitement de l'air.

10. Bâtiment selon la revendication 9, **caractérisé en ce que** l'installation (**30**) de climatisation et/ou de traitement de l'air est située au sol et/ou en sous-sol.

11. Bâtiment selon la revendication 8, **caractérisé en ce qu**'il comprend au niveau ou au dessus de la salle informatique la plus haute (**5**) au moins :
- une chambre d'apport d'air frais qui est séparée de la zone froide (**Zf**) de la salle la plus haute par une cloison ajourée autorisant une libre circulation de l'air et qui est raccordée à l'installation de climatisation et/ou de traitement de l'air,
- une chambre d'évacuation de l'air chaud qui est séparée de la zone chaude (**Zc**) de la salle la plus haute par une cloison ajourée autorisant une libre circulation de l'air et qui est raccordée à l'installation de climatisation et/ou de traitement de l'air.

12. Bâtiment selon la revendication 11, **caractérisé en ce que** l'installation (**30**) de climatisation et/ou de traitement de l'air est située au dessus ou au niveau de la salle informatique la plus haute (**5**).

13. Bâtiment selon l'une des revendications précédentes, **caractérisé en ce que** les moyens d'apport d'air frais comprennent au moins une bouche (2**0)** d'entrée d'air extérieur au niveau de la zone froide (**Zf**) de la salle informatique la plus basse.

14. Bâtiment selon l'une des revendications précédentes, **caractérisé en ce que** les moyens d'évacuation de l'air chaud comprennent au moins une bouche (**23**) de sortie ouverte vers l'extérieur au niveau de la zone chaude (**Zc**) de la salle informatique la plus haute.

15. Bâtiment selon la revendication 13 ou 14, **caractérisé en ce que** chaque bouche est obturée par au moins un volet mobile (**21,24**).

16. Procédé de régulation de la température des salles informatiques d'un bâtiment selon l'une des revendications 8 à 15, **caractérisé en ce qu**'il consiste notamment à :
- dans un mode de fonctionnement, dit hiver, lorsque l'air extérieur est à une température inférieure ou égale à une température limite ou maximale préconisée, mettre en oeuvre les étapes suivantes :
- évacuer vers l'extérieur une partie de l'air chaud en provenance de la colonne d'air chaud,
- prélever de l'air extérieur et le mélanger avec la partie restante de l'air chaud en provenance de la colonne d'évacuation (**Ce**) pour obtenir un air mélangé frais à une température comprise dans une plage de température préconisée,
- alimenter la colonne d'alimentation **(Cₐ)** avec l'air mélangé frais obtenu,
- dans un mode de fonctionnement, dit mi-saison, lorsque l'air extérieur est à une température supérieure à la température limite ou maximale préconisée et inférieure la température de l'air en sortie des matériels informatiques ou électroniques, mettre en oeuvre les étapes suivantes :
- évacuer vers l'extérieur une partie au moins de l'air chaud en provenance de la colonne d'air chaud,
- prélever de l'air extérieur et le mélanger éventuellement avec la partie restante de l'air chaud en provenance de la colonne d'évacuation (**Ce**) pour obtenir un air mélangé,
- refroidir l'air extérieur ou l'air mélangé pour obtenir un air frais à une température comprise dans la plage de température préconisée,
- alimenter la colonne d'alimentation **(Cₐ)** avec l'air mélangé frais obtenu,
- dans un mode de fonctionnement, dit été, lorsque l'air extérieur est à une température supérieure à la température de l'air en sortie des matériels informatiques ou électroniques, mettre en oeuvre les étapes suivantes :
- recycler totalement l'air chaud en provenance de la colonne d'évacuation,
- refroidir l'air chaud recyclé pour obtenir un air recyclé à une température comprise dans une plage de température préconisée,
- alimenter la colonne d'alimentation **(Cₐ)** avec l'air recyclé frais obtenu.

17. Procédé selon la revendication 16 d'un bâtiment selon la revendication **15**, **caractérisé en ce qu**'il consiste notamment dans un mode de fonctionnement dit économique à assurer l'alimentation en air de la colonne d'apport et l'évacuation de l'air chaud de la colonne d'évacuation **(Cₑ)** en partie au moins par convection naturelle en contrôlant l'ouverture des volets des bouches d'entrée et de sortie.

18. Procédé selon la revendication 16 ou 17, **caractérisé en ce qu**'il comprend une étape de contrôle et d'ajustement de l'hygrométrie de l'air alimentant la colonne d'apport.

19. Procédé de régulation de la température des salles informatiques d'un bâtiment selon l'une des revendications 13 à 15, **caractérisé en ce qu**'il consiste à assurer l'alimentation en air de la colonne d'alimentation **(Cₐ)** et/ou l'évacuation de l'air chaud de la colonne d'évacuation (**Ce**) en partie au moins par convection naturelle.

20. Procédé selon l'une des revendications 16 à 19, **caractérisé en ce qu**'il comprend une étape de filtration de l'air.

## Claims

1. Building comprising at least two vertically superimposed computer rooms (**2,3,4,5**) each limited by a peripheral wall (**6**) and separated from each other by an intermediate floor (**7**) and which each contain computer cabinets (**11**) for computer or electronic equipment (**25**), building wherein:
- each computer room (**2,3,4,5**) comprises at least one interior wall (**10**) formed in part or less by the computer cabinets (**11**) and which separates the interior volume of each computer room into a hot zone (**Zc**) and a cold zone (**Zf**), since the air cannot flow between the hot zone (**Zc**) and the cold zone (**Zf**) without passing through the computer cabinets (**11**),
- the hot (**Zc**) and respectively cold zones (**Zf**) are superimposed one floor above the other,
- each intermediate floor (**7,8,9**) is perforated to allow free circulation of air, on the one hand, between the superimposed hot zones (**Zc**), and, on the other hand, between the superimposed cold zones (**Zf**), all superimposed cold zones forming a supply column of fresh air (**Cₐ**) and all the superimposed hot zones forming an exhaust column of hot air (**Cₑ**),
- the floors (**7,8,9**), the perimeter walls (**6**) and interior walls (**10**) are adapted to prevent a direct flow of air between the supply column (**Cₐ**) and the exhaust column (**Cₑ**),
- and the building further comprises means (**20,30**) for providing fresh air in the supply column (**Cₐ**) and means for evacuating (**23,30**) hot air from the exhaust column (**Cₑ**).

2. Building according to claim 1, **characterised in that**:
- the peripheral walls (**6**) of the computer rooms (**2,3,4,5**) are superimposed and form a part of the load-bearing building structure,
- and the interior walls (**10**) are superimposed from one computer room to the other.

3. Building according to one of the preceding claims, **characterised in that** each computer room (**2,3,4,5**) has a height of to 2 to 3 m and the building contains at least four floors of computer rooms.

4. Building according to one of the preceding claims, **characterised in that** each computer cabinet (**11**) comprises partitions (**30**) and / or at least partly removable partitions (**31**) suited for obstructing the free flow of air in parts of the cabinet (**11**) without computer hardware or electronics.

5. Building according to one of the preceding claims, **characterised in that** it comprises computer hardware or electronics (**25**) disposed in at least one computer cabinet and adapted to draw in fresh air at a side facing (**26**) the corresponding cold zone (**Zf**) and to pump out warm air at a side (**27**) facing the corresponding hot zone (**Zc**).

6. Building according to one of the preceding claims, **characterised in that** the surface, measured at floor level, of each cold zone (**Zf**) is greater than or equal to the surface area, measured at floor level, of the corresponding hot zone (**Zc**).

7. Building according to one of the preceding claims, **characterised in that** it comprises at least one staircase (**17**) and / or a lift (**18**) for access to the computer rooms (2**, 3, 4, 5**) fitted outside the computer rooms.

8. Building according to claims 1 to 7, **characterised in that** the means of bringing fresh air and exhausting hot air comprise fresh air and hot air pipes connected to at least one air conditioning and / or air treatment installation (**30**).

9. Building according to claim 8, **characterised in that** it comprises under the lowest computer room (**2**) at least:
- a fresh air supply chamber (**35**) which is separated from the cold area (**Zf**) of the lowest room (**2**) by a perforated floor (**36**) allowing free air circulation and is connected to the air conditioning and / or air treatment installation (**30**),
- a hot air exhaust chamber (**37**) which is separated from the hot area (**Zc**) of the lowest room (**2**) by a perforated floor (**38**) allowing free air circulation and is connected to the air conditioning and / or air treatment installation (**30**).

10. Building according to claim 9, **characterised in that** the air conditioning and / or treatment installation (**30**) is located on the ground and / or basement.

11. Building according to claim 8, **characterised in that** it comprises at the level of or above the highest computer room (**5**) at least:
- a fresh air supply chamber which is separated from the cold area (**Zf**) of the highest room by a perforated floor allowing free air circulation and is connected to the air conditioning and / or air treatment installation,
- a hot air exhaust chamber which is separated from the hot area (Zc) of the highest room by a perforated floor allowing free air circulation and is connected to the air conditioning and / or air treatment installation.

12. Building according to claim 11, **characterised in that** the air conditioning and / or treatment installation (30) is located at the level of or above the highest computer room (5).

13. Building according to one of the preceding claims, **characterised in that** the means of bringing fresh air in comprise at least one exterior air intake vent (20) at the cold zone (Zf) level of the lowest computer room.

14. Building according to one of the preceding claims, **characterised in that** the means for evacuating hot air comprises at least one outlet vent (**23**) open to the outside at the hot zone (**Zc**) of the highest computer room.

15. Building according to claim 13 or 14, **characterised in that** each vent is closed by at least one movable flap (**21, 24**).

16. Process for regulating the temperature of the computer rooms of a building according to claims 8 to 15, **characterised in that** it especially consists of:
- in an operating mode, called winter, when the outside air is at a temperature less than or equal to a limit or maximum recommended temperature, implementing the following steps:
- evacuating part of the hot air from the hot air column to the outside,
- taking outside air and mixing it with the remaining part of the hot air from the exhaust column (**Cₑ**) to get fresh mixed air at a temperature within the recommended temperature range,
- supplying the supply column (**Cₐ**) with the mixed fresh air obtained,
- in a operation mode, called mid-season, when the outside air is at a temperature above the limit or maximum recommended temperature and lower, the temperature of the air coming out of the computer or electronic equipment, implementing the following steps:
- evacuating at least part of the hot air from the hot air column to the outside,
- taking outside air and mixing it as needed with the remaining part of the hot air from the exhaust column (**Cₑ**) to get fresh mixed air,
- cooling the outside air or mixed air to obtain fresh air at a temperature within the recommended temperature range,
- supplying the supply column (**Cₐ**) with the mixed fresh air obtained,
- in a operation mode, called summer, when the outside air is at a temperature above the temperature of the air coming out of the computer or electronic equipment, implementing the following steps:
- completely recycling the hot air from the exhaust column,
- cooling the recycled hot air to obtain recycled air at a temperature within the recommended temperature range,
- supplying the supply column (**Cₐ**) with the recycled fresh air obtained.

17. Process according to claim 16 of a building according to claim 15, **characterised in that** it comprises a so-called economic mode to ensure the supply of air from the intake column and exhaust hot air from the exhaust column (**Cₑ**) at least partly by natural convection by controlling the opening of inlet and outlet flaps.

18. Process according to claim 16 or 17, **characterised in that** it comprises a step of checking and adjusting the humidity of the air supplying to the supply column.

19. Process for regulating the temperature of the computer rooms of a building according to claim 13 to 15, **characterised in that** it ensures the supply of air from the supply column (**Cₐ**) and exhaust hot air from the exhaust column (**Cₑ**) at least partly by natural convection.

20. Process according to claim 16 to 19, **characterised in that** it comprises a step of air filtering.

## Patentansprüche

1. Gebäude, das mindestens zwei EDV-Räume (2, 3, 4, 5), die in die Richtung der Höhe übereinander liegen, aufweist, die jeweils von einer Umfangswand (6) abgegrenzt und voneinander durch einen Zwischenboden (7) getrennt sind, und die jeweils EDV-Schränke (11) zum Aufnehmen von EDV- oder elektronischem Material (25) enthalten, Gebäude, in dem:
- jeder EDV-Raum (2, 3, 4, 5) mindestens eine Innenwand (10) aufweist, die zum Teil oder weniger von den EDV-Schränken (11) ausgebildet ist, und die das Innenvolumen jedes EDV-Raums in eine heiße Zone (Zc) und eine kalte Zone (Zf) trennt, wobei die Luft zwischen der heißen Zone (Zc) und der kalten Zone (Zf) nur zirkulieren kann, indem sie durch die EDV-Schränke (11) durchgeht,
- die heißen Zonen (Zc) bzw. kalten Zonen (Zf) von einer Etage zur anderen übereinander liegen,
- jeder Zwischenboden (7, 8, 9) derart gelocht ist, dass eine freie Zirkulation der Luft einerseits zwischen den übereinander liegenden heißen Zonen (Zc) und andererseits zwischen den übereinander liegenden kalten Zonen (Zf) erlaubt wird, wobei die Einheit der übereinander liegenden kalten Zonen (Zf) eine Frischluftzufuhrkolonne (Cₐ) bildet und die Einheit der übereinander liegenden warmen Zonen eine Kolonne zum Ableiten der warmen Luft (Cₑ) bildet,
- wobei die Böden (7, 8, 9), die Umfangswände (6) und die Innenwände (10) angepasst sind, um für eine direkte Zirkulation von Luft zwischen der Versorgungskolonne (Cₐ) und der Ableitungskolonne (Cₑ) ein Hindernis zu bilden,
- und wobei das Gebäude ferner Mittel zum Zuführen (20) von Frischluft in der Versorgungskolonne (Cₐ) und Mittel zum Ableiten (23) der warmen Luft der Ableitungskolonne (Cₑ) aufweist.

2. Gebäude nach Anspruch 1, **dadurch gekennzeichnet, dass**:
- die Umfangswände (6) der EDV-Räume (2, 3, 4, 5) übereinander liegen und einen Teil der Tragstruktur des Gebäudes bilden,
- und die Innenwände (10) von einem EDV-Raum zum anderen übereinander liegen.

3. Gebäude nach einem der vorhergehenden Ansprüche, **dadurch gekennzeichnet, dass** jeder EDV-Raum (2, 3, 4, 5) eine Höhe zwischen 2 m und 3 m besitzt, und dass das Gebäude wenigstens vier Etagen EDV-Räume aufweist.

4. Gebäude nach einem der vorhergehenden Ansprüche, **dadurch gekennzeichnet, dass** jeder EDV-Schrank (11) Wände (31a) und/oder Trennwände (31), die mindestens zum Teil abnehmbar sind, aufweist, die angepasst sind, um für die freie Zirkulation der Luft in den Teilen des Schranks (11), die kein EDV- oder elektronisches Material enthalten, ein Hindernis zu bilden.

5. Gebäude nach einem der vorhergehenden Ansprüche, **dadurch gekennzeichnet, dass** es EDV- oder elektronisches Material (25) enthält, das in mindestens einem EDV-Schrank angeordnet und angepasst ist, um Frischluft auf dem Niveau einer Seite (26), die zu der entsprechenden kalten Zone (Zf) ausgerichtet ist, anzusaugen, und um warme Luft auf dem Niveau einer Seite (27), die zu der entsprechenden warmen Zone (Zc) ausgerichtet ist, zurück zu befördern.

6. Gebäude nach einem der vorhergehenden Ansprüche, **dadurch gekennzeichnet, dass** die Oberfläche jeder kalten Zone (Zf), die auf dem Niveau des Fußbodens gemessen wird, größer oder gleich der Oberfläche ist, die auf dem Niveau des Fußbodens der entsprechenden warmen Zone (Zc) gemessen wird.

7. Gebäude nach einem der vorhergehenden Ansprüche, **dadurch gekennzeichnet, dass** es mindestens eine Treppe (17) und/oder einen Lift (18), der außerhalb der EDV-Räume angeordnet ist, für den Zugang zu den EDV-Räumen (2, 3, 4, 5) aufweist.

8. Gebäude nach einem der Ansprüche 1 bis 7, **dadurch gekennzeichnet, dass** die Mittel zur Frischluftzufuhr und zur Ableitung der warmen Luft Frischluftleitungen und Warmluftleitungen aufweisen, die an mindestens eine Klimaanlage (30) und/oder Luftaufbereitungsanlage angeschlossen sind.

9. Gebäude nach Anspruch 8, **dadurch gekennzeichnet, dass** es unter dem am tiefsten liegenden EDV-Raum (2) mindestens Folgendes aufweist:
- eine Kammer (35) zur Frischluftzufuhr, die von der kalten Zone (Zf) des am tiefsten liegenden Raums (2) durch einen gelochten Fußboden (36), der eine freie Zirkulation der Luft erlaubt, getrennt ist, und der an die Klimaanlage (30) und/oder Luftaufbereitungsanlage angeschlossen ist,
- eine Kammer (37) zur Ableitung der warmen Luft, die von der warmen Zone (Zc) des am tiefsten liegenden Raums (2) durch einen gelochten Fußboden (38) getrennt ist, der eine freie Zirkulation der Luft erlaubt, und der an die Klimaanlage (30) und/oder Luftaufbereitungsanlage angeschlossen ist.

10. Gebäude nach Anspruch 9, **dadurch gekennzeichnet, dass** die Klimaanlage (30) und/oder Luftaufbereitungsanlage auf dem Boden und/oder im Untergeschoss liegt.

11. Gebäude nach Anspruch 8, **dadurch gekennzeichnet, dass** es auf dem Niveau oder oberhalb des am höchsten liegenden EDV-Raums (5) mindestens Folgendes aufweist:
- eine Kammer zum Zuführen der frischen Luft, die von der kalten Zone (Zf) des am höchsten liegenden Raums durch eine gelochte Wand getrennt ist, die eine freie Zirkulation der Luft erlaubt, und die an die Klimaanlage und/oder Luftaufbereitungsanlage angeschlossen ist,
- eine Kammer zum Ableiten der warmen Luft, die von der warmen Zone (Zc) des am höchsten liegenden Raums durch eine gelochte Wand getrennt ist, die eine freie Zirkulation der Luft erlaubt und die an die Klimaanlage und/oder Luftaufbereitungsanlage angeschlossen ist.

12. Gebäude nach Anspruch 11, **dadurch gekennzeichnet, dass** die Klimaanlage (30) und/oder Luftaufbereitungsanlage oberhalb oder auf dem Niveau des am höchsten liegenden EDV-Raums (5) liegt.

13. Gebäude nach einem der vorhergehenden Ansprüche, **dadurch gekennzeichnet, dass** die Frischluftzufuhrmittel mindestens eine Eingangsöffnung (20) von Außenluft auf dem Niveau der kalten Zone (Zf) des am tiefsten liegenden EDV-Raums aufweisen.

14. Gebäude nach einem der vorhergehenden Ansprüche, **dadurch gekennzeichnet, dass** die Mittel zum Ableiten der warmen Luft mindestens eine Ausgangsöffnung (23), die nach außen auf dem Niveau der warmen Zone (Zc) des am höchsten liegenden EDV-Raums offen ist, aufweisen.

15. Gebäude nach Anspruch 13 oder 14, **dadurch gekennzeichnet, dass** jede Öffnung durch mindestens eine bewegliche Klappe (21, 24) verschlossen ist.

16. Verfahren zum Regeln der Temperatur der EDV-Räume eines Gebäudes nach einem der Ansprüche 8 bis 15, **dadurch gekennzeichnet, dass** es insbesondere aus Folgendem besteht:
- bei einer Betriebsart, die Winterbetriebsart genannt wird, wenn die Außenluft eine Temperatur hat, die kleiner oder gleich einer Grenztemperatur oder maximalen empfohlenen Temperatur ist, Umsetzen der folgenden Schritte:
- Ableiten nach außen eines Teils der warmen Luft, die von der Warmluftkolonne kommt,
- Entnehmen der Außenluft und Mischen mit dem restlichen Teil der warmen Luft, die von der Ableitungskolonne (Cₑ) kommt, um eine frische Mischluft mit einer Temperatur zu erhalten, die in einem empfohlenen Temperaturbereich liegt,
- Versorgen der Versorgungskolonne (Cₐ) mit der erhaltenen frischen Mischluft,
- bei einer Betriebsart, die Zwischensaisonbetriebsart genannt wird, wenn die Außenluft eine Temperatur hat, die höher ist als die Grenztemperatur oder empfohlene maximale Temperatur und niedriger als die Temperatur der Luft am Ausgang des EDV-Materials oder elektronischen Materials, Umsetzen der folgenden Schritte:
- Ableiten mindestens eines Teils der warmen Luft, die von der Warmluftkolonne kommt, nach außen,
- Entnehmen der Außenluft und eventuelles Vermischen mit dem restlichen Teil der warmen Luft, die von der Ableitungskolonne (Cₑ) kommt, um eine gemischte Luft zu erhalten,
- Abkühlen der Außenluft oder der gemischten Luft, um eine frische Luft mit einer Temperatur zu erhalten, die in dem empfohlenen Temperaturbereich liegt,
- Versorgen der Versorgungskolonne (Cₐ) mit der erhaltenen frischen Mischluft,
- bei einer Betriebsart, die Sommerbetriebsart genannt wird, wenn die Außenluft eine Temperatur hat, die höher ist als die Temperatur am Ausgang des EDV-Materials oder elektronischen Materials, Umsetzen der folgenden Schritte:
- komplettes Recycling der warmen Luft, die von der Ableitungskolonne kommt,
- Abkühlen der recycelten warmen Luft, um eine recycelte Luft mit einer Temperatur zu erhalten, die in einem empfohlenen Temperaturbereich liegt,
- Versorgen der Versorgungskolonne (Cₐ) mit der erhaltenen frischen recycelten Luft.

17. Verfahren nach Anspruch 16 eines Gebäudes nach Anspruch 15, **dadurch gekennzeichnet, dass** es insbesondere darin besteht, bei einer Betriebsart, die Ökobetriebsart genannt wird, die Versorgung der Zufuhr- und Ableitungskolonne der warmen Luft der Ableitungskolonne (Cₑ) zum Teil mindestens durch natürliche Konvektion sicherzustellen, indem das Öffnen der Klappen der Eingangs- und Ausgangsöffnungen gesteuert wird.

18. Verfahren nach Anspruch 16 oder 17, **dadurch gekennzeichnet, dass** es einen Schritt des Steuerns und des Anpassens der Luftfeuchtigkeit der Luft, die die Zufuhrkolonne versorgt, aufweist.

19. Verfahren zum Regeln der Temperatur der EDV-Räume eines Gebäudes nach einem der Ansprüche 13 bis 15, **dadurch gekennzeichnet, dass** es darin besteht, die Luftversorgung der Versorgungskolonne (Cₐ) und/oder die Ableitung der warmen Luft der Ableitungskolonne (Cₑ) mindestens zum Teil durch natürliche Konvektion sicherzustellen.

20. Verfahren nach einem der Ansprüche 16 bis 19, **dadurch gekennzeichnet, dass** es einen Schritt des Luftfilterns aufweist.
